# EUROPÄISCHE PATENTSCHRIFT

(11) **EP 3 076 207 B1**
(45) Veröffentlichungstag und Bekanntmachung des Hinweises auf die Patenterteilung: **16.08.2017**
(21) Anmeldenummer: 16162921.7
(22) Anmeldetag: 30.03.2016
(51) Int. Cl.: G01V 8/20

(54) **OPTOELEKTRONISCHER SENSOR**
OPTOELECTRONIC SENSOR
CAPTEUR OPTOÉLECTRONIQUE

(30) Priorität: 02.04.2015 DE 102015105149
(43) Veröffentlichungstag der Anmeldung: 05.10.2016
(73) Patentinhaber: SICK AG, 79183 Waldkirch/Breisgau (DE)
(72) Erfinder: Hörsch, Ingolf, 79102 Freiburg (DE); Merettig, Gerhard, 79350 Sexau (DE); Bergbach, Roland, 79367 Weisweil (DE)
(74) Vertreter: Manitz Finsterwald Patentanwälte PartmbB

(56) Entgegenhaltungen:
- EP-A1- 2 194 397
- EP-A1- 2 226 652
- EP-A1- 2 390 620
- EP-A1- 2 442 141
- DE-A1- 10 212 432
- DE-A1- 10 318 764
- DE-A1- 19 852 412
- DE-A1-102004 022 812
- US-A- 5 583 334

## Beschreibung

Die Erfindung betrifft einen optoelektronischen Sensor mit wenigstens einer Lichtquelle zum Aussenden von Sendelicht durch eine Sendeapertur in einen Überwachungsraum und einem Lichtempfänger zur Detektion von Empfangssignalen, die den Überwachungsraum verlassen.

Derartige optoelektronische Sensoren umfassen zum Beispiel Lichtschranken. Hier wird Licht in einen Überwachungsraum gesendet und auf der gegenüberliegenden Seite des Überwachungsraumes von einem Empfänger detektiert. Eine Unterbrechung des Lichtweges führt dazu, dass kein Licht am Empfänger ankommt und auf ein Objekt im Überwachungsraum geschlossen werden kann. Bei Reflexionslichtschranken befindet sich anstelle des Empfängers ein Reflektor, der das Licht bei ununterbrochenem Strahlengang wieder zurück in Richtung des Senders reflektiert, wo es durch einen entsprechend angeordneten Empfänger detektiert werden kann. Bei einer solchen Anordnung befinden sich also Sender und Empfänger auf der gleichen Seite des Überwachungsraumes.

Mehrere nebeneinander angeordnete Lichtschranken bilden ein Lichtgitter, wodurch ein größerer räumlicher Bereich überwacht werden kann, oder die Bewegung eines Gegenstandes beobachtet werden kann, der zu unterschiedlichen Zeitpunkten die Lichtwege unterschiedlicher Lichtschranken unterbricht.

Andere optoelektronische Sensoren umfassen Lichttaster, die zum Beispiel zur Entfernungsmessung geeignet sind. Wird Licht aus dem Überwachungsraum zurückreflektiert, so kann auf die Anwesenheit eines Objektes und z.B. aus der Lichtlaufzeit auf dessen Entfernung geschlossen werden. Bei sogenannten Triangulationstastern befinden sich Sender und Empfänger in einem räumlichen Abstand zueinander auf derselben Seite des Überwachungsraumes. Je nach Entfernung des reflektierenden Objektes im Überwachungsraum trifft reflektiertes Licht an einer unterschiedlichen Stelle auf den Lichtempfänger. Aus der Lage eines reflektierten Lichtpunktes auf dem Empfänger lässt sich nach in an sich bekannter Weise die Entfernung des Objektes nach dem geometrischen Triangulationsprinzip bestimmen.

Ein optoelektronischer Sensor mit den Merkmalen des Oberbegriffs des Anspruchs 1 ist aus EP 2 442 141 A1 bekannt.

US 5,583,334 beschreibt die Abschaltung von ausgewählten Sender/Empfängerpaaren im Falle von einem Defekt. Die Anpassung der Energieaufnahme durch Aussparen einzelner Lichtquellen einer Objekterfassungseinrichtung ist der DE 103 18 764 A1 zu entnehmen. EP 2 194 397 A1 beschreibt einen modifizierten Triangulationslichttaster mit einem Sender und einer Matrix aus lichtempfindlichen Elementen.

Aufgabe der vorliegenden Erfindung ist es, einen optoelektronischen Sensor anzugeben, der bei äußerst kompakter und kostengünstiger Ausgestaltung einen einfachen und zuverlässigen Betrieb gewährleistet.

Diese Aufgabe wird mit einem optoelektronischen Sensor mit den Merkmalen des Anspruches 1 gelöst. Spezielle vorteilhafte Anwendungen des optoelektronischen Sensors in der Ausgestaltung als Lichtgitter oder als optischer Taster sind Gegenstand des Anspruches 8 bzw. des Anspruches 9. Unteransprüche sind auf bevorzugte Ausgestaltungen gerichtet.

Erfindungsgemäß ist dazu zunächst vorgesehen, dass als Lichtquelle eine Multi-Pixel-Leuchtdiode zum Einsatz kommt. Eine solche Multi-Pixel-Leuchtdiode ist ein einzelner Halbleiterkristall, der mehrere lichtemittierende Segmente aufweist. Die Ansteuerung der einzelnen lichtemittierenden Segmente (im Folgenden auch Lichtquellensegmente) erfolgt durch eine entsprechend strukturierte Elektrode in dem Halbleiterkristall. Der Leuchtmechanismus entspricht dabei dem physikalischen Prinzip einer Leuchtdiode oder eines oberflächenemittierenden Halbleiterlasers (zum Beispiel eines VCSEL, Vertical Cavity Surface Emitting Laser).

Mit einer solchen Halbleiterleuchtdiodenstruktur ist ein sehr kompakter Aufbau möglich, der trotzdem eine räumlich modulierte und bei entsprechender Ansteuerung auch zeitlich modulierte Ansteuerung einzelner Lichtquellensegmente ermöglicht.

Der erfindungsgemäße optoelektronische Sensor weist weiterhin einen Lichtempfänger zur Detektion von Empfangssignalen auf, die den Überwachungsraum verlassen. Dabei kann sich je nach Ausgestaltung des optoelektronischen Sensors der Lichtempfänger auf der der Lichtquelle gegenüberliegenden Seite des Überwachungsraumes befinden oder auf derselben Seite, wenn sich auf der gegenüberliegenden Seite des Überwachungsraumes ein entsprechend angeordneter Reflektor befindet.

Der erfindungsgemäße optoelektronische Sensor weist außerdem eine Steuereinrichtung auf, die mit dem Lichtempfänger und mit der Vielzahl von Lichtquellensegmenten der Lichtquelle verbunden ist. Auf diese Weise ist es möglich, dass die Steuereinrichtung die einzelnen Lichtquellensegmente individuell ansteuert. Die Steuereinrichtung kann dazu derart ausgestaltet sein, die Lichtquellensegmente individuell und zeitabhängig anzusteuern.

Die erfindungsgemäß vorgesehene Steuereinrichtung weist insbesondere einen Einstellmodus und einen Betriebsmodus auf. Der Einstellmodus ist dabei so ausgestaltet, dass die Lichtquellensegmente nacheinander angesteuert werden und das Empfangssignal am Lichtempfänger von der Steuereinrichtung auf seine Stärke hin ausgewertet wird. Im Betriebsmodus werden dann von der Steuereinrichtung diejenigen Lichtquellensegmente angesteuert, bei denen das Empfangssignal während des Einstellmodus eine gewünschte Eigenschaft aufweist. Die Steuereinrichtung kann zum Beispiel so eingerichtet sein, dass der Einstellmodus vom Benutzer zum Beispiel nach dem Anschalten des Sensors oder als Zwischenüberprüfung ausgewählt werden kann.

Die besonders kompakte Anordnung unter Verwendung einer Multi-Pixel-Leuchtdiode (im Folgenden auch Multi-Pixel-LED) im Zusammenwirken mit der erfindungsgemäß beanspruchten Steuereinrichtung ermöglicht einen schnellen und präzisen Betrieb des optoelektronischen Sensors und der Auswahl der optimalen Betriebsbedingungen durch Festlegung derjenigen Lichtquellensegmente, die bei dem Betrieb zum Einsatz kommen sollen.

Es ist mit der erfindungsgemäßen Anordnung möglich, genau diejenigen Lichtquellensegmente auszuwählen, die für den aktuell zum Einsatz kommenden optoelektronischen Sensor das optimale Signal bieten. Dadurch, dass eine Multi-Pixel-LED zum Einsatz kommt, lässt sich diese Auswahl sehr einfach, platzsparend und kostengünstig realisieren.

Die einzelnen Lichtquellensegmente können zum Beispiel jeweils einzelne Einzelleuchtdiodenstrukturen aufweisen, die in einer gewünschten lateralen Abstrahlform angeordnet sind. Dabei werden solche Einzelleuchtdiodenstrukturen beispielsweise durch entsprechend in eine Halbleiterlaserschichtstruktur geätzte räumliche Strukturen, epitaktisch aufgewachsenene Strukturen oder sogenannte "Nanowires" gebildet. Die räumliche Anordnung dieser einzelnen Einzelleuchtdiodenstrukturen bildet dann eine laterale Abstrahlform.

Bei einer anderen Ausgestaltung ist die laterale Abstrahlform der einzelnen Lichtquellensegmente durch die Form der einzelnen Leuchtdiodenstruktur selbst vorgegeben. So kann zum Beispiel in einer Halbleiterleuchtdiodenschichtstruktur eine solche geometrische Form durch einen lithographischen Prozess gebildet sein, die der gewünschten lateralen Abstrahlform entspricht.

Bei einer erfindungsgemäßen Ausgestaltung kann dabei insbesondere vorgesehen sein, dass die einzelnen Lichtquellensegmente unterschiedliche Abstrahlformen aufweisen und in einer solchen Anordnung angeordnet sind, dass die Lichtquelle eine Ansammlung von in den gewünschten Abstrahlformen ausgestalteten Lichtquellensegmenten aufweist.

Durch die Aufteilung der Lichtquelle in einzelne Lichtquellensegmente ist es für die Steuereinrichtung möglich, während des Einstellmodus diejenigen Lichtquellensegmente auszuwählen, bei denen ein Empfangssignal eine gewünschte Eigenschaft aufweist. Insbesondere ist es zum Beispiel möglich, dasjenige Lichtquellensegment oder diejenigen Lichtquellensegmente auszuwählen, bei denen das Empfangssignal eine Schwelle überschreitet oder einen möglichst großen Wert annimmt.

Auf diese Weise ermöglicht der erfindungsgemäße optoelektronische Sensor eine Selbstausrichtung zwischen Lichtquelle und Lichtempfänger, indem die Steuereinrichtung diejenigen Lichtquellensegmente beziehungsweise dasjenige Lichtquellensegment auswählt, bei dem zum Beispiel das Empfangssignal oberhalb einer Schwelle liegt. Niedrigere Empfangssignale würden zu einem schlechteren Signal-Rausch-Verhältnis führen und insofern eine ungenauere Messung oder Detektion bedeuten.

Dabei ist es besonders bevorzugt, wenn ein einzelnes Lichtquellensegment oder eine Gruppe benachbarter Lichtquellensegmente ausgewählt wird. Dies entspricht auch einem Hauptanwendungsfall, in dem mithilfe der erfindungsgemäß möglichen Selbstausrichtung berücksichtigt werden kann, dass das Sendelicht möglichst vollständig auf den Reflektor eines Reflexionslichtgitters beziehungsweise einer Reflexionslichtschranke oder auf den Empfänger einer Transmissionslichtschranke beziehungsweise eines Transmissionslichtgitters fällt.

Grundsätzlich ist es aber auch denkbar, dass bei dem Einstellmodus solche Lichtquellensegmente zur Auswahl kommen, die nicht notwendigerweise benachbart sind. Derartiges kann zum Beispiel vorkommen, wenn ein Reflektor auf der dem Sensor gegenüberliegenden Seite eines Überwachungsraumes keine homogene Reflektivität aufweist oder zum Beispiel ein Empfänger in einer Transmissionsanordnung keine homogene räumliche Empfangscharakteristik hat.

Außerdem ist es möglich, solche Lichtquellensegmente vom Betrieb auszunehmen, deren Licht auf Objekte fällt, die sich bewusst und in Kenntnis eines Benutzers im Überwachungsraum befinden.

Mit dem erfindungsgemäßen optoelektronischen Sensor mit der erfindungsgemäß ausgestalteten Steuereinrichtung ist trotzdem gewährleistet, dass diejenigen Lichtquellensegmente zum Einsatz kommen, die für ein möglichst gutes Empfangssignal mit einem möglichst großen Signal-Rausch-Verhältnis sorgen.

Besonders vorteilhaft ist es, wenn sich die einzelnen Lichtquellensegmente eine gemeinsame Sendeoptik teilen, die bevorzugterweise auch die Sendeapertur darstellt. Diese Sendeoptik ist zum Beispiel eine Sendelinse. Dies ist insbesondere unter Berücksichtigung der besonders kompakten Anordnung des erfindungsgemäßen optoelektronischen Sensors wünschenswert, weil dann nur eine einzelne Sendeoptik notwendig ist, die gegebenenfalls sogar bei entsprechenden Prozesstechniken auf dem Halbleiterkristall selbst realisiert werden kann, der die Sendelichtquelle bildet.

Der erfindungsgemäße optoelektronische Sensor kann zum Beispiel als Reflexionslichtschranke, als Reflexionslichtgitter, als Transmissionslichtschranke, als Transmissionslichtgitter oder optischer Taster, insbesondere auch als Triangulationstaster oder lichtlaufzeitbasierter entfernungsmessender Taster ausgestaltet sein. Die besonderen Vorteile oder besonderen Ausgestaltungen solcher speziellen optoelektronischen Sensoren ergeben sich aus den oben geschilderten Vorteilen des erfindungsgemäßen optoelektronischen Sensors.

Die bei dem erfindungsgemäßen optoelektronischen Sensor mögliche individuelle Ansteuerbarkeit der einzelnen Lichtquellensegmente ermöglicht auch noch zusätzliche Anwendungsmodi, die mit der erfindungsgemäß möglichen Auswahl der optimalen Lichtquellensegmente in vorteilhafter Weise zusammenwirken.

So ist es zum Beispiel möglich, dass durch Auswahl einzelner Lichtquellensegmente eine besonders günstige oder gewünschte Strahlquerschnittsform festgelegt wird, die an die gewünschte Anwendung optimal angepasst ist.

Außerdem ist zum Beispiel denkbar, dass durch Auswahl der entsprechenden Anzahl der abstrahlenden Lichtquellensegmente der Querschnitt des ausgesendeten Lichtstrahles auch in seiner Größe optimal an die zu erwartenden Objekte beziehungsweise an die Reflektor- oder Empfängergröße angepasst wird.

So ist es zum Beispiel grundsätzlich möglich, dass mit der erfindungsgemäß zum Einsatz kommenden Multi-Pixel-LED die Strahlgröße und Querschnittsform festgelegt wird. Dies kann zum Beispiel nach der erfindungsgemäß implementierten Selbstausrichtung passieren, wenn die Strahlquerschnittsform oder die Strahlquerschnittsgröße manuell an besondere Umstände angepasst werden soll.

Ebenso ist es denkbar, dass je nach der spezifischen Anwendung eine manuelle Ausrichtung des Strahles der erfindungsgemäßen Selbstausrichtung nachgeschaltet werden soll. Durch nachträgliche Auswahl entsprechender Lichtquellensegmente lässt sich die Strahlrichtung manuell verändern.

Zudem ist es möglich, eine zeitlich modulierte Ansteuerung der einzelnen Lichtquellensegmente zu implementieren, die einen zeitlichen abgestimmten Überwachungsmodus eines sich gegebenenfalls zeitlich ändernden Überwachungsraumes ermöglicht, um insbesondere die Bewegung von Objekten innerhalb des Überwachungsraumes in ihrer zeitlichen Entwicklung nachzuverfolgen. Insbesondere können dabei einzelne Lichtquellensegmente zeitversetzt angesteuert werden, um die Präsenz eines Objektes in einem bestimmten räumlichen Bereich des Überwachungsraumes individuell feststellen zu können.

Schließlich ist es auch denkbar, dass die laterale Querschnittsform des abgestrahlten Sendelichtes an eine Kontraststruktur an einem zu erwartenden Objekt angepasst ist (die darauf zum Beispiel als Erkennungszeichen aufgebracht sind). Dazu werden diejenigen Lichtquellensegmente ausgewählt, die gewährleisten, dass das gewünschte Muster auf das Objekt projiziert wird.

Ebenso ist es möglich, dass die laterale Abstrahlform der Lichtsegmente so ausgewählt wird, dass zu erwartende Strukturen in dem zu detektierenden Objekt (zum Beispiel Kanten oder starke Modulationen der Reflexionseigenschaften) optimal erfasst werden, indem zum Beispiel eine in einer Richtung stark ausgedehnte laterale Querschnittsform des ausgesendeten Lichtes gewählt wird, die senkrecht zu einer erwarteten Kante oder eines Sprunges in der Reflektivität angeordnet ist.

Die Erfindung wird anhand der beiliegenden schematischen (nicht maßstabsgetreuen) Figuren im Detail erläutert. Es zeigen
- Fig. 1: eine mögliche Anordnung und Form von Lichtquellensegmenten einer bei einem erfindungsgemäßen optoelektronischen Sensor zum Einsatz kommenden Lichtquelle,
- Fig. 2: eine andere Anordnung beziehungsweise Ausgestaltung der Lichtquellensegmente,
- Fig. 3: ein Beispiel, wie die im Betriebsmodus angesteuerten Lichtquellensegmente ausgewählt werden können,
- Fig. 4: eine schematische Anordnung einer Ausgestaltung eines erfindungsgemäßen optoelektronischen Sensors im Betrieb, und
- Fig. 5: eine Schemadarstellung der Funktionsweise einer möglichen Zusatzausstattung zur manuellen Regulierung.

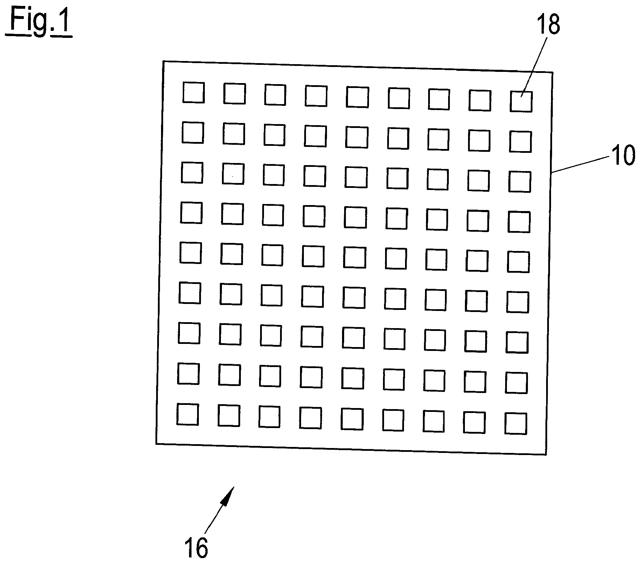

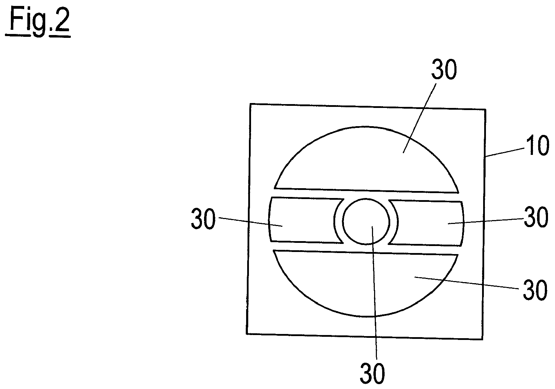

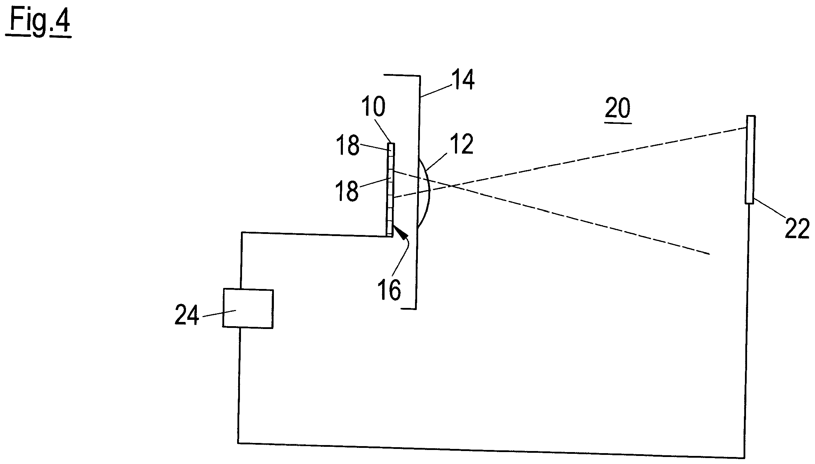

Die prinzipielle Anordnung eines optoelektronischen Sensors am Beispiel einer Ausgestaltung als Transmissionslichttaster ist in Fig. 4 schematisch gezeigt. Man erkennt eine Sendelichtquelle 10, die einzelne Segmente 18, 30 aufweist, die mithilfe der Fig. 1 und 2 noch im Detail erläutert werden. Die Sendelichtquelle sendet Licht durch eine Sendelinse 12, die auch als Apertur wirkt. Diese Anordnung ist in einem nur angedeuteten Gehäuse 14 aufgenommen.

Bezugsziffer 16 bezeichnet hier eine Draufsicht auf die Sendelichtquelle 10 aus Richtung der Linse 12. Diese Draufsicht ist in Fig. 1 gezeigt. Man erkennt hier unterschiedliche Sendesegmente 18.

Das Sendelicht der Sendelichtquelle 10 (Fig. 4) tritt in einen Überwachungsraum 20 ein, der bei dieser Ausgestaltung auf seiner gegenüberliegenden Seite durch einen Empfänger 22 begrenzt wird.

Bei der Sendelichtquelle 10 handelt es sich um eine Halbleiterleuchtdiodenstruktur. Die Sendelichtquelle 10 ist dabei durch einen einzigen Kristall gebildet. Auf diesem Kristall befinden sich einzelne Segmente 18, deren Form zum Beispiel in Fig. 1 erkennbar ist. Es handelt sich hierbei um einzelne Segmente, die bei der Ausgestaltung der Fig. 1 Quadrate oder Rechtecke bilden, die nebeneinander in dem Abstand einiger Mikrometer angeordnet sind. Die einzelnen Lichtquellensegmente werden dabei durch entsprechend lateral ausgeformte Bereiche eines Halbleiterkristalles gebildet. Im Fall der Fig. 1 handelt es sich dabei um entsprechend beabstandet ausgebildete, lithographisch hergestellte quadratische Strukturen 18.

Die einzelnen Segmente umfassen bei dem beschriebenen Beispiel Quadrate zum Beispiel in der Größenordnung von 100x100µm oder anderen Formen in dieser Größenordnung. Der Abstand zwischen den einzelnen Lichtsegmenten 18 beträgt zum Beispiel 20µm.

Die einzelnen Segmente 18 sind individuell ansteuerbar - ähnlich der Auslesegeometrie eines CCD Bildsensors - durch Spaltenselektionsleitungen und Zeilenselektionsleitungen.

Sowohl der Empfänger 22 als auch die Sendelichtquelle 10 sind mit einer Steuer- bzw. Auswerteeinrichtung 24 verbunden, die nur schematisch dargestellt ist und zum einen zur Auswahl der im Betrieb anzusteuernden Lichtquellenelemente 18 dient.

Die Steuereinrichtung 24 ist außerdem mit dem Empfangselement 22 verbunden, das zum Beispiel eine Photodiode oder ein entsprechendes CCD Array aufweist.

In einem Einstellmodus wird zunächst ausgewählt, welche Lichtquellensegmente 18 während des Betriebes der in Fig. 4 gezeigten Lichtschranke zum Einsatz kommen sollen. Dazu werden von der Steuereinrichtung 24 die einzelnen Lichtquellensegmente 18 zeitlich versetzt zueinander angesteuert und das resultierende Signal an der Empfangseinheit 22 detektiert. Auf diese Weise ist feststellbar, bei welchen Lichtquellensegmenten 18 an der Empfängereinheit 22 ein Signal ankommt, das über einer gewünschten vorgegebenen Schwelle liegt. Im Betrieb, bei der die Lichtschranke der Fig. 4 zum Einsatz kommt, werden dann nur diejenigen Lichtquellensegmente 18 angesteuert, bei denen dieser Schwellwert überschritten wird.

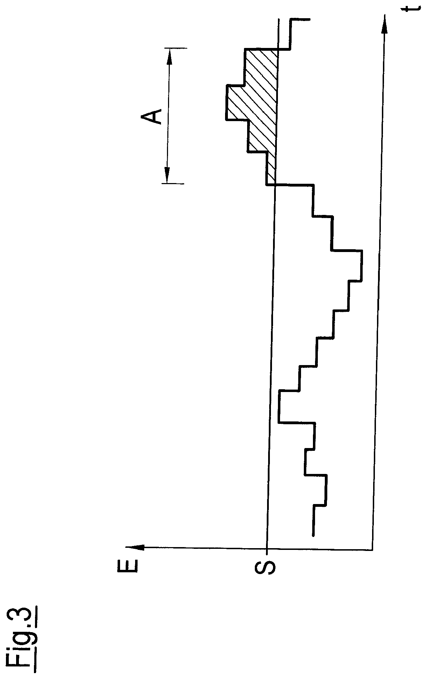

Dies ist in Fig. 3 gezeigt. Die einzelnen Lichtquellensegmente 18 werden zeitlich versetzt zueinander in dem Einstellmodus angesteuert. Das resultierende Empfangssignal E weist je nach zu einem Zeitpunkt eingeschaltetem Lichtquellensegment einen höheren oder niedrigeren Wert auf, so dass sich im zeitlichen Verlauf (während dessen unterschiedliche Segmente 18 nacheinander angesteuert werden) ein stufenförmiges Empfangssignal E zeigt. Man erkennt, dass einige Segmente, deren individuelle Ansteuerung sich im Verlauf (in Abhängigkeit der Zeit t) des im Diagramm dargestellten Empfangssignales E widerspiegelt, Empfangssignale (schraffiert dargestellt) oberhalb eines Schwellwertes S liefern. Nur die zugehörigen Lichtquellensegmente werden dann im Betrieb der Lichtschranke eingesetzt (im rechten Teil der Fig. 3 als angesteuerte Segmente A markiert). Auf diese Weise ist sichergestellt, dass im Betrieb nur diejenigen Lichtquellensegmente zum Einsatz kommen, die ein optimales Signal-Rausch-Verhältnis garantieren.

Auf diese Weise ist es möglich, dass bei jeder individuellen Anwendung diejenigen Lichtquellensegmente zum Einsatz kommen, die der besonderen Geometrie im Anwendungsfall entsprechen. Auf diese Weise ist es nicht mehr notwendig, eine exakte Justierung der Sendelichtquelle 10 und des Empfangselementes 22 bei der Implementierung des Sensors vorzunehmen. Stattdessen kann auch bei leichten Fehljustierungen durch die Auswahl der optimalen Sendelichtquellensegmente 18 ein optimales Signal-Rausch-Verhältnis erreicht werden.

Damit kann z.B. auch ausgeglichen werden, dass durch die Sendeapertur, die durch die Linse 12 gebildet wird, zum Beispiel in der in Fig. 4 gezeigten Anordnung manche der Lichtquellensegmente 18 Licht aussenden, das begrenzt durch die Apertur der Linse 12 nicht auf den Empfänger 22 fällt, während andere Lichtquellensegmente hier deutlich günstiger sind.

Die Montage, Justierung und Einstellung einer entsprechenden Lichtschranke im Anwendungsbereich ist also stark vereinfacht und insofern deutlich kostengünstiger und trotzdem gleichermaßen sicher.

Fig. 2 zeigt eine andere Anordnung von möglichen Lichtquellensegmenten 30. Hier sind unterschiedlich geformte Lichtquellensegmente 30 erkennbar, deren Form und Anordnung an die individuelle Geometrie angepasst sein können.

Die einzelnen Lichtquellensegmente sind hier durch entsprechend lateral strukturierte Bereiche der Halbleiterleuchtdiodenkristallstruktur gebildet. Alternativ ist es auch möglich, dass die einzelnen Halbleiterlichtquellensegmente durch Einzelleuchtdiodenstrukturen gebildet werden, die in der entsprechenden Form nebeneinander auf dem Halbleiterkristall lithographisch erzeugt worden sind.

Bei der Halbleiterleuchtdiodenstruktur kann es sich jeweils zum Beispiel um eine Leuchtdiodenschichtstruktur oder zum Beispiel um eine Halbleiterlaserschichtstruktur (zum Beispiel einem VCSEL (Vertical Cavity Surface Emitting Laser)) handeln.

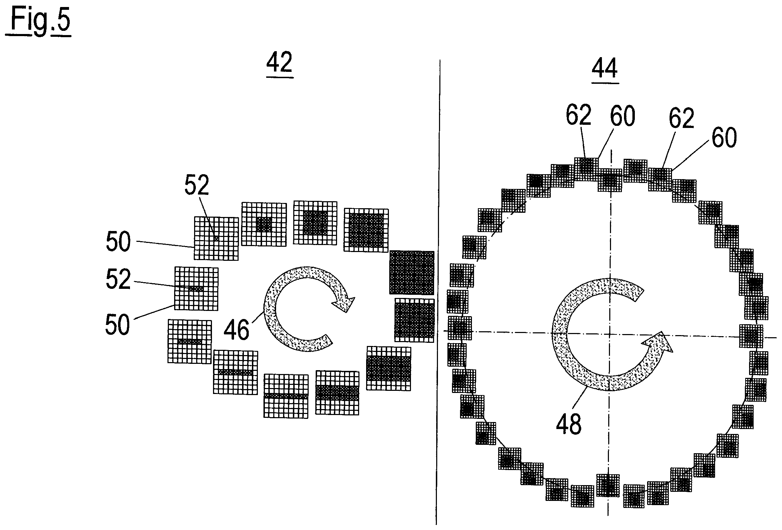

Abschließend wird anhand der Fig. 5 erläutert, wie der erfindungsgemäße Einsatz einer Multi-Pixel-LED vorteilhaft weiterentwickelt werden kann. Wie beschrieben findet erfindungsgemäß eine Selbstausrichtung des Sendelichtes zwischen Lichtquelle und Lichtempfänger statt. Trotzdem ist es denkbar, dass eine weitere Anpassung gewünscht ist, wenn es spezifische Anforderungen oder Geometrien erfordern. Insofern kann bei einer Weiterbildung vorgesehen sein, dass Strahlquerschnitt, Strahlform und Strahlrichtung manuell reguliert, insbesondere nachreguliert, werden können.

Anhand der Fig. 5 wird erläutert, wie dies besonders einfach und praktisch implementiert werden kann. Fig. 5 zeigt dabei schematisch das Einstellschema.

In nicht dargestellter Weise ist an der Vorrichtung ein Drehknopf vorgesehen, mit dessen Hilfe unterschiedliche Muster, Größen und Ausrichtungen des Sendestrahles gewählt werden können. Dazu werden die einzelnen Lichtquellensegmente angesteuert, so dass die gewünschte Strahlform, der gewünschte Strahlquerschnitt oder die gewünschte Strahlrichtung bestimmt wird.

Dabei zeigt die im linken Teil 42 der Fig. 5 dargestellte Drehrichtung 46, wie der Strahlquerschnitt in seiner Größe festgelegt wird. Dazu werden, wie es in den Schemabildern 50 ausgehend von links oben durch Drehung in Richtung 46 erreicht wird, zunächst immer mehr Lichtquellensegmente 52 angesteuert (dargestellt in der Figur durch die dunkel dargestellten angesteuerten Lichtquellensegmente 52), bis gemäß der Darstellung im linken Teil 42 der Fig. 5 rechts oben alle vorhandenen Lichtquellensegmente angesteuert sind. Bei weiterer Drehung wird dann unter Veränderung der Strahlform die Anzahl der angesteuerten Lichtquellensegmente wieder verkleinert, bis wiederum bei einer Drehknopfstellung links oben nur ein Lichtquellensegment 52 angesteuert wird. Auf diese Weise kann die Querschnittsform und -größe durch Rechtsdrehung des entsprechenden Drehknopfes bewirkt werden. Von einem Inkrement des Drehknopfes zum nächsten Inkrement verändert sich die Strahlform bzw. der Strahlquerschnitt immer nur um eines oder wenige angesteuerte Lichtquellensegmente, so dass es für den Benutzer möglich ist, die gewünschte Strahlquerschnittsform- bzw. den gewünschten Strahlquerschnitt einfach und intuitiv auszuwählen.

Nachdem durch Rechtsdrehung des Drehknopfes die entsprechende Auswahl getroffen worden ist und zum Beispiel (bei entsprechender Ausgestaltung) durch Drücken des Drehknopfes festgelegt worden ist, kann der Drehknopf dann so vorgesehen sein, dass durch Linksdrehung 48, wie es im rechten Teil 44 der Fig. 5 dargestellt ist, mit der festgelegten Strahlquerschnittsgröße in einem nächsten Schritt die Strahlrichtung gewählt werden kann. Dazu werden entsprechende Lichtquellensegmente 62 der im rechten Teil 44 der Fig. 5 dargestellten Schemadarstellungen 60 ausgewählt. Man sieht hier zum Beispiel, dass im linken oberen Quadranten des rechten Teils 44 der Fig. 5 das Feld der angesteuerten Lichtquellensegmente 62 sich im Wesentlichen im linken oberen Teil des verfügbaren Felds 60 von angesteuerten Lichtquellensegmenten befindet. Im linken unteren Quadranten des rechten Teiles 44 der Fig. 5 bewegt sich das Feld der angesteuerten Lichtquellensegmente hingegen im linken unteren Teil des Feldes 60 der anzusteuernden Lichtquellensegmente. Auf diese Weise ist auch bei der Auswahl der Strahlrichtung gemäß dem rechten Teil 44 der Fig. 5 gewährleistet, dass der Benutzer mit einem Inkrement des Drehknopfes immer nur eine inkrementale Änderung der Strahlrichtung bewirkt, so dass eine intuitive und einfache Auswahl möglich ist. Wiederum kann die gewählte Einstellung dann durch Drücken des Drehknopfes festgelegt werden.

Dabei zeigt Fig. 5 eine besonders einfache und vorteilhafte Möglichkeit, wie eine entsprechende manuelle Regulierung der Strahlform, des Strahlquerschnittes bzw. der Strahlrichtung mit einem entsprechend ausgestalteten Drehknopf möglich ist. Selbstverständlich sind auch andere Einstellmöglichkeiten, z.B. an einem Touch-Screen, denkbar.

Durch eine solche manuelle Einstellbarkeit ist es möglich, eine einfache Nachregulierung der Strahlquerschnittsform, -größe und -richtung durchzuführen, nachdem die erfindungsgemäße automatisierte Selbstausrichtung stattgefunden hat. Dies kann von Nutzen sein, wenn die speziellen Gegebenheiten und äußeren Umstände des Einsatzortes und des Einsatzzweckes des optoelektronischen Sensors dies erfordern oder sinnvoll machen.

Grundsätzlich möglich, aber nicht unbedingt notwendig ist es, dass die Schemadarstellungen in der Fig. 5 zum Beispiel auf einem Bildschirm an dem erfindungsgemäßen optoelektronischen Sensor auch angezeigt werden, um die Einstellung noch zu vereinfachen.

Grundsätzlich kann die beschriebene manuelle Auswahl auch ohne Vorschaltung der erfindungsgemäß vorgesehenen automatisierten Selbstausrichtung zum Einsatz kommen, wenn die spezifischen Gegebenheiten einer entsprechenden Anwendung die erfindungsgemäß automatisiert vorgesehene Selbstausrichtung nicht erfordern.

### Bezugszeichenliste

- 10: Sendelichtquelle
- 12: Sendelinse
- 14: Gehäuse
- 16: Draufsicht auf die Sendelichtquelle 10 aus Richtung der Sendelinse 12
- 18: Lichtquellensegment
- 20: Überwachungsraum
- 22: Lichtempfänger
- 24: Steuereinrichtung
- 30: Lichtquellensegment
- 42, 44: Figurenteil
- 46, 48: Drehrichtung eines Auswahldrehknopfes
- 50: Schemadarstellung der Lichtquellensegmente
- 52: Darstellung der anzusteuernden Lichtquellensegmente
- 60: Schemadarstellung der Lichtquellensegmente
- 62: Darstellung der anzusteuernden Lichtquellensegmente
- E: Empfangssignal
- t: Zeit
- S: Schwellenwert
- A: zeitlicher Bereich mit einem Empfangssignal oberhalb des Schwellenwertes

## Patentansprüche

1. Optoelektronischer Sensor mit
- wenigstens einer Leuchtdioden- oder Halbleiterlaser-Lichtquelle (10) zum Aussenden von Sendelicht durch eine Sendeapertur in einen Überwachungsraum (20),
wobei die Lichtquelle (10) einen Halbleiterkristall mit einer Vielzahl von individuell ansteuerbaren, in einem lateralen Muster angeordneten Lichtquellensegmenten (18, 30) umfasst,
- wenigstens einem Lichtempfänger (22) zur Detektion von Empfangssignalen, die den Überwachungsraum (20) verlassen,
- einer Steuereinrichtung (24), die mit dem wenigstens einen Lichtempfänger (22) und mit der Vielzahl von Lichtquellensegmenten (18, 30) verbunden ist, um die Lichtquellensegmente (18, 30) individuell zu ihrem Betrieb anzusteuern und Empfangssignale des Lichtempfängers (22) auszuwerten,
**dadurch gekennzeichnet, dass** die Steuereinrichtung (24) einen Einstellmodus und einen Betriebsmodus aufweist, und (i) im Einstellmodus die Lichtquellensegmente (18, 30) nacheinander ansteuert und das dabei jeweils erhaltene Empfangssignal jeweils auf seine Stärke hin auswertet und (ii) im Betriebsmodus diejenigen Lichtquellensegmente (18, 30) ansteuert, bei denen das Empfangssignal (E) im Einstellmodus eine Stärke oberhalb einer vorgegebenen Schwelle (S) aufweist, um eine Selbstausrichtung zwischen Lichtquelle und Lichtempfänger durchzuführen; oder mehrere Lichtquellensegmente (18, 30) zum gleichzeitigen Betrieb ansteuert, die derart ausgewählt sind, dass die Summe der im Einstellmodus gemessenen und zu den ausgewählten Lichtquellensegmenten korrespondierenden Empfangssignale oberhalb einer vorgegebenen Schwelle liegt, um eine Selbstausrichtung zwischen Lichtquelle und Lichtempfänger durchzuführen.

2. Optoelektronischer Sensor nach Anspruch 1, **dadurch gekennzeichnet, dass** die Lichtquellensegmente (18, 30) jeweils durch eine Leuchtdiodenstruktur mit einer gewünschten lateralen Abstrahlform gebildet sind.

3. Optoelektronischer Sensor nach Anspruch 1, **dadurch gekennzeichnet, dass** die Lichtquellensegmente jeweils mehrere in einer gewünschten lateralen Abstrahlform angeordnete einzelne Leuchtdiodenstrukturen umfasst.

4. Optoelektronischer Sensor nach einem der vorhergehenden Ansprüche, **gekennzeichnet durch** eine Sendeoptik (12), vorzugsweise eine Linse, die derart angeordnet ist, dass das Licht aller Lichtquellensegmente (18, 30), die sich auf dem einen Halbleiterkristall befinden, durch diese Sendeoptik strahlt.

5. Optoelektronischer Sensor nach einem der vorhergehenden Ansprüche, **gekennzeichnet durch** eine Einrichtung zur zusätzlichen manuellen Einstellung der anzusteuernden Lichtquellensegmente.

6. Optoelektronischer Sensor nach einem der vorhergehenden Ansprüche, **dadurch gekennzeichnet, dass** es sich um eine Lichtschranke handelt, wobei die Sendelichtquelle (10) auf der einen Seite des Überwachungsraumes (20) angeordnet ist, und der Empfänger (22) auf der gegenüberliegenden Seite.

7. Optoelektronischer Sensor nach einem der Ansprüche 1 bis 5, **dadurch gekennzeichnet, dass** es sich um eine Reflexionslichtschranke handelt, bei der sich die Sendelichtquelle und der Empfänger auf derselben Seite des Überwachungsraumes befinden und sich ein Reflektor auf der gegenüberliegenden Seite des Überwachungsraumes befindet, wobei bei ununterbrochenem Strahlengang das Sendelicht von der Sendelichtquelle auf den Reflektor fällt und von diesem zurück zum Empfänger reflektiert wird.

8. Lichtgitter mit einer Anzahl räumlich versetzt zueinander angeordneter optoelektronischer Sensoren nach einem der Ansprüche 6 oder 7.

9. Optischer Taster, insbesondere ein nach dem Triangulationsprinzip oder dem Lichtlaufzeitprinzip arbeitender entfernungsmessender optischer Taster, mit einem optoelektronischen Sensor nach einem der Ansprüche 1 bis 5.

## Claims

1. An optoelectronic sensor comprising
- at least one light emitting diode light source or semiconductor laser light source (10) for transmitting transmitted light through a transmission aperture into a monitored zone (20),
wherein the light source (10) comprises a semiconductor crystal having a plurality of light source segments (18, 30) which are individually controllable and which are arranged in a lateral pattern;
- at least one light receiver (22) for detecting received signals which leave the monitored zone (20); and
- a control device (24) which is connected to the at least one light receiver (22) and to the plurality of light source segments (18, 30) to individually control the light source segments (18, 30) for their operation and to evaluate received signals of the light receiver (22), **characterized in that** the control device (24) has a setting mode and an operating mode and (i) activates the light source segments (18, 30) one after the other in the setting mode and evaluates the respective received signal obtained in so doing with respect to its strength in each case and (ii), in the operating mode, activates those light source segments (18, 30) with which the received signal (E) has a strength above a predefined threshold (S) in the setting mode in order to carry out a self-alignment between the light source and the light receiver; or activates a plurality of light source segments (18, 30) for simultaneous operation which are selected such that the sum of the received signals measured in the setting mode and corresponding to the selected light source segments lies above a predefined threshold in order to carry out a self-alignment between the light source and the light receiver.

2. An optoelectronic sensor in accordance with claim 1, **characterized in that** the light source segments (18, 30) are formed by a respective light emitting diode structure having a desired lateral irradiation form.

3. An optoelectronic sensor in accordance with claim 1, **characterized in that** the light source segments have a respective plurality of individual light emitting diode structures arranged in a desired lateral irradiation form.

4. An optoelectronic sensor in accordance with any one of the preceding claims, **characterized by** a transmission optics (12), preferably a lens, which is arranged such that the light of all the light source segments (18, 30) which are located at the one semiconductor crystal is irradiated through said transmission optics.

5. An optoelectronic sensor in accordance with any one of the preceding claims, **characterized by** a device for the additional manual setting of the light source segments to be activated.

6. An optoelectronic sensor in accordance with any one of the preceding claims, **characterized in that** it is a light barrier, with the transmitted light source (10) being arranged at the one side of the monitored zone (20) and the receiver (22) at the oppositely disposed side.

7. An optoelectronic sensor in accordance with any one of the claims 1 to 5, **characterized in that** it is a reflection light barrier in which the transmitted light source and the receiver are located at the same side of the monitored zone and a reflector is located at the oppositely disposed side of the monitored zone, wherein, provided the beam path is uninterrupted, the transmitted light from the transmitted light source is incident onto the reflector and is reflected back to the receiver by said reflector.

8. A light grid having a number of optoelectronic sensors in accordance with one of the claims 6 or 7 which are arranged spatially offset from one another.

9. An optical sensor, in particular a distance-measuring optical sensor which works in accordance with the triangulation principle or with the time-of-flight principle, having an optoelectronic sensor in accordance with any one of the claims 1 to 5.

## Revendications

1. Capteur optoélectronique, comportant
- au moins une source de lumière (10) à diode électroluminescente ou à laser à semi-conducteur pour émettre une lumière d'émission à travers une ouverture d'émission dans un espace à surveiller (20),
la source de lumière (10) comprenant un cristal à semi-conducteur pourvu d'une multitude de segments de source de lumière (18, 30) pilotables individuellement et agencés dans un motif latéral,
- au moins un récepteur de lumière (22) pour détecter des signaux de réception qui quittent l'espace à surveiller (20),
- un dispositif de commande (24) qui est connecté audit au moins un récepteur de lumière (22) et à la multitude de segments de source de lumière (18, 30) en vue de piloter individuellement les segments de source de lumière (18, 30) pour les faire fonctionner et en vue d'évaluer les signaux de réception du récepteur de lumière (22),
**caractérisé en ce que**
le dispositif de commande (24) présente un mode de réglage et un mode de fonctionnement, et (i) en mode de réglage, il pilote les segments de source de lumière (18, 30) les uns après les autres et évalue le signal de réception respectivement reçu vis-à-vis de son intensité et (ii) en mode de fonctionnement, il pilote ceux des segments de source de lumière (18, 30) dans lesquels le signal de réception (E) présente, en mode de réglage, une intensité supérieure à un seuil donné (S), afin d'effectuer une auto-orientation entre la source de lumière et le récepteur de lumière ;
ou, en vue d'un fonctionnement simultané, il pilote plusieurs segments de source de lumière (18, 30), qui sont choisis de telle sorte que la somme des signaux de réception mesurés en mode de réglage et correspondant aux segments de source de lumière choisis est supérieure à un seuil donné, afin d'effectuer une auto-orientation entre la source de lumière et le récepteur de lumière.

2. Capteur optoélectronique selon la revendication 1, **caractérisé en ce que** les segments de source de lumière (18, 30) sont formés chacun par une structure de diode électroluminescente ayant une forme d'émission latérale désirée.

3. Capteur optoélectronique selon la revendication 1, **caractérisé en ce que** les segments de source de lumière comprennent chacun plusieurs structures individuelles de diode électroluminescente agencées selon une forme d'émission latérale désirée.

4. Capteur optoélectronique selon l'une des revendications précédentes, **caractérisé par** une optique d'émission (12), de préférence une lentille qui est agencée de telle sorte que la lumière de tous les segments de source de lumière (18, 30) qui se trouvent sur un cristal semi-conducteur sort à travers ladite optique d'émission.

5. Capteur optoélectronique selon l'une des revendications précédentes, **caractérisé par** un dispositif pour le réglage manuel supplémentaire des segments de source de lumière à piloter.

6. Capteur optoélectronique selon l'une des revendications précédentes **caractérisé en ce qu'**il s'agit d'une barrière lumineuse, la source de lumière d'émission (10) étant agencée sur un côté de l'espace à surveiller (20) et le récepteur (22) étant agencé sur le côté opposé.

7. Capteur optoélectronique selon l'une des revendications 1 à 5, **caractérisé en ce qu'**il s'agit d'une barrière lumineuse à réflexion dans laquelle la source de lumière d'émission et le récepteur se trouvent sur le même côté de l'espace à surveiller et un réflecteur se trouve sur le côté opposé de l'espace à surveiller, et lors d'un trajet optique ininterrompu la lumière d'émission tombe depuis la source de lumière d'émission sur le réflecteur et est réfléchie par celui-ci en retour vers le récepteur.

8. Grille lumineuse comportant un certain nombre de capteurs optoélectroniques selon l'une des revendications 6 ou 7 agencés en décalage dans l'espace les uns par rapport aux autres.

9. Palpeur optique, en particulier palpeur optique qui fonctionne selon le principe de triangulation ou selon le principe du temps de parcours de lumière et qui mesure des distances, comportant un capteur optoélectronique selon l'une des revendications 1 à 5.
